# EUROPEAN PATENT APPLICATION

(11) **EP 4 675 269 A1**
(43) Date of publication of application: **07.01.2026**
(21) Application number: 24763473.6
(22) Date of filing: 30.01.2024
(51) Int. Cl.: G01N 27/30, B32B 15/04

(54) **ELECTRODE, AND ELECTROCHEMICAL MEASURING SYSTEM**

(30) Priority: 28.02.2023 JP 2023029927
(71) Applicant: Nitto Denko Corporation, Ibaraki-shi Osaka 567-8680 (JP)
(72) Inventor: TOSHIMA, Ayaka, Ibaraki-shi, Osaka 567-8680 (JP); KATAGIRI, Masayoshi, Ibaraki-shi, Osaka 567-8680 (JP); IGUCHI, Honami, Ibaraki-shi, Osaka 567-8680 (JP)
(74) Representative: Gill Jennings & Every LLP
(86) International application number: PCT/JP2024/002898
(87) International publication number: WO 2024/180988

(57) **Abstract**

An electrode 1 includes a substrate 2, a metal underlying layer 3, and an electrically conductive carbon layer 4 in order toward one side in a thickness direction. A material for the metal underlying layer 3 is an alloy containing a first metal and a second metal. The first metal has a first potential window and first activity obtained by using a first electrochemical measurement system 10A including a first sample electrode 1A including the substrate 2, the metal underlying layer 3 made of the first metal, and the electrically conductive carbon layer 4. The second metal has a second potential window and second activity obtained by using a second electrochemical measurement system 10B. The first metal and the second metal are different from each other. The second activity is equal to or greater than the first activity. The first potential window is equal to or greater than the second potential window.

## Description

### TECHNICAL FIELD

The present invention relates to an electrode and an electrochemical measurement system.

### BACKGROUND ART

An electrode including a substrate, a metal underlying layer, and an electrically conductive carbon layer is known (ref: for example, Patent Document 1 below). Patent Document 1 describes Examples in which a material for the metal underlying layer is titanium.

### Citation List

### Patent Document

Patent Document 1: International Publication No. 2021/193631

### SUMMARY OF THE INVENTION

### PROBLEM TO BE SOLVED BY THE INVENTION

The electrode is used as an electrode for electrochemical measurement, and at that time, a balance between excellent activity with respect to a ferricyanide compound and a wide potential window is required.

The present invention provides an electrode and an electrochemical measurement system which have an excellent balance between activity with respect to a ferricyanide compound and a wide potential window.

### MEANS FOR SOLVING THE PROBLEM

The present invention [1] includes an electrode including a substrate, a metal underlying layer, and an electrically conductive carbon layer in order toward one side in a thickness direction, wherein a material for the metal underlying layer is an alloy containing a first metal and a second metal; the first metal has a first potential window obtained by using a first electrochemical measurement system including a first sample electrode including the substrate, the metal underlying layer made of the first metal, and the electrically conductive carbon layer, and first activity with respect to a ferricyanide compound obtained by using the first electrochemical measurement system; the second metal has a second potential window obtained by using a second electrochemical measurement system including a second sample electrode including the substrate, the metal underlying layer made of the second metal, and the electrically conductive carbon layer, and second activity with respect to the ferricyanide compound obtained by using the second electrochemical measurement system; the first metal and the second metal are different from each other; the second activity is equal to or greater than the first activity; and the first potential window is equal to or greater than the second potential window.

The present invention [2] includes the electrode described in [1], wherein the first metal or the second metal is at least one selected from the group consisting of tantalum, titanium, aluminum, zirconium, niobium, and tungsten.

The present invention [3] includes the electrode described in [1] or [2], wherein the first metal is at least one selected from the group consisting of tantalum, titanium, aluminum, zirconium, and niobium.

The present invention [4] includes the electrode described in any one of [1] to [3], wherein the second metal is at least one selected from the group consisting of zirconium, niobium, and tungsten.

The present invention [5] includes the electrode described in any one of [1] to [4], wherein the first metal or the second metal includes two selected from the group consisting of tantalum, titanium, aluminum, zirconium, niobium, and tungsten.

The present invention [6] includes the electrode described in any one of [1] to [5], wherein the substrate is a resin film.

The present invention [7] includes the electrode described in any one of [1] to [6] being an electrode for electrochemical measurement.

The present invention [8] includes an electrochemical measurement system including the electrode described in [7].

### EFFECT OF THE INVENTION

In the electrode of the present invention, the material for the metal underlying layer is the alloy containing the first metal and the second metal, the second activity is equal to or greater than the first activity, and the first potential window is equal to or greater than the second potential window. Therefore, the electrode has an excellent balance between the activity with respect to the ferricyanide compound and the wide potential window.

The electrochemical measurement system has the excellent balance between the activity with respect to the ferricyanide compound and the wide potential window.

### BRIEF DESCRIPTION OF THE DRAWINGS

FIG. 1 shows a cross-sectional view of one embodiment of an electrode of the present invention.
FIG. 2 shows a cross-sectional view of a sample electrode.
FIG. 3 shows a schematic view of one embodiment of an electrochemical measurement system of the present invention.
FIG. 4 shows a relationship between a width of a potential window and ferricyanide activity in a first metal and a second metal, and shows an example in which the first metal is titanium.
FIG. 5 shows a relationship between a width of a potential window and ferricyanide activity in a first metal and a second metal, and shows an example in which the first metal is tantalum.
FIG. 6 shows a relationship between a width of a potential window and ferricyanide activity in a first metal and a second metal, and shows an example in which the first metal is aluminum.
FIG. 7 shows a relationship between a width of a potential window and ferricyanide activity in a first metal and a second metal, and shows an example in which the first metal is zirconium.
FIG. 8 shows a relationship between a width of a potential window and ferricyanide activity in a first metal and a second metal, and shows an example in which the first metal is niobium.

### DESCRIPTION OF EMBODIMENTS

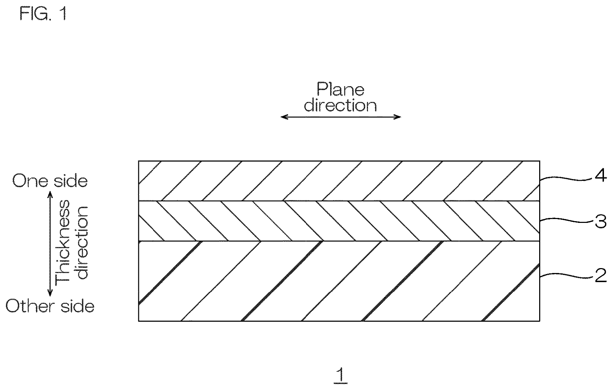

One embodiment of an electrode of the present invention is described with reference to FIGS. 1 to 8.

### 1. Electrode 1

As shown in FIG. 1, an electrode 1 has a thickness. The electrode 1 extends in a plane direction. The plane direction is perpendicular to a thickness direction. The electrode 1 has a film shape or a sheet shape. The film and the sheet are not distinguished. A thickness of the electrode 1 is, for example, 2 µm or more, preferably 10 µm or more, and for example, 1000 µm or less, preferably 500 µm or less. In the present embodiment, the electrode 1 includes a substrate 2, a metal underlying layer 3, and an electrically conductive carbon layer 4 in order toward one side in the thickness direction.

### 1.1 Substrate 2

The substrate 2 is disposed in the other end portion of the electrode 1 in the thickness direction. The substrate 2 extends in the plane direction. The substrate 2 has the film shape or the sheet shape. Examples of a material for the substrate 2 include resins, ceramics, and metals. The substrate 2 preferably has flexibility. As the material for the substrate 2, preferably, a resin is used from the viewpoint of ensuring the flexibility of the substrate 2. In other words, preferably, the substrate 2 is the resin film. Examples of the resin include polyester resins, acetate resins, polyether sulfone resins, polycarbonate resins, polyamide resins, polyimide resins, polyolefin resins, (meth)acrylate resins, polyvinyl chloride resins, polyvinylidene chloride resins, polystyrene resins, polyvinyl alcohol resins, polyarylate resins, and polyphenylene sulfide resins. These resins may be used alone or in combination of two or more. As the resin, preferably, a polyester resin is used, preferably, a polyethylene terephthalate is used. When the material is the ceramics, the substrate 2 is a ceramic foil. When the material is the metal, the substrate 2 is a metal foil. The thickness of the substrate 2 is, for example, 1.9 µm or more, preferably 9 µm or more, and for example, 999 µm or less, preferably 499 µm or less.

### 1.2 Metal Underlying Layer 3

The metal underlying layer 3 is disposed on one surface of the substrate 2 in the thickness direction. The metal underlying layer 3 is in contact with one surface of the substrate 2 in the thickness direction. The metal underlying layer 3 extends in the plane direction. The metal underlying layer 3 is an underlying layer. The underlying layer assists electrical conductivity of the electrically conductive carbon layer 4.

The material for the metal underlying layer 3 is an alloy. The alloy contains a first metal and a second metal.

### 1.2.1 First Metal

The first metal has a first potential window and first activity.

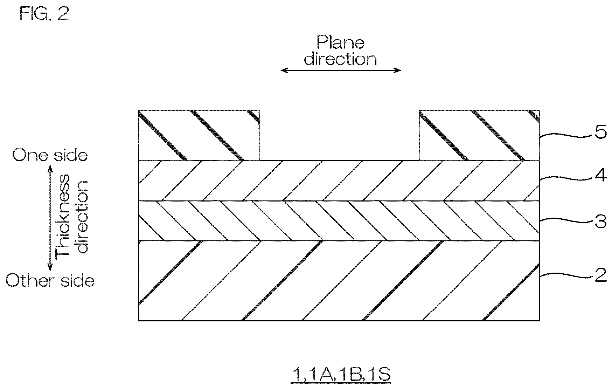

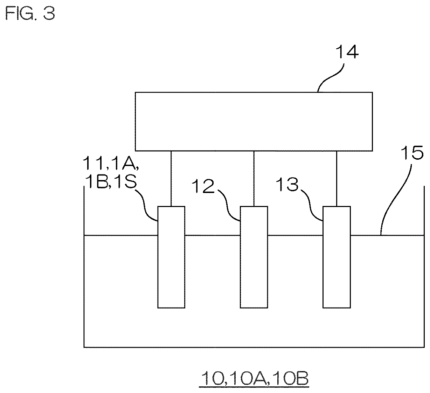

The first potential window is obtained using a first electrochemical measurement system 10A shown in FIG. 3. In the electrode 1, the potential window is required to be wide. As shown in FIG. 3, the first electrochemical measurement system 10A includes a first sample electrode 1A. As shown in FIG. 2, the first sample electrode 1A includes the substrate 2, the metal underlying layer 3 made of the first metal, and the electrically conductive carbon layer 4. The first sample electrode 1A further includes an insulating tape 5.

The first activity is evaluated in ΔEp with respect to the ferricyanide compound determined by CV using the first electrochemical measurement system 10A. The low ΔEp means the high first activity.

The first sample electrode 1A, measurement of the first potential window using the first sample electrode 1A, and the measurement of the first activity using the first sample electrode 1A are described later.

The first metal is, for example, a typical element and/or a transition element. Preferably, the first metal is at least one selected from the group consisting of tantalum, titanium, aluminum, zirconium, and niobium. More preferably, the first metal is at least one selected from the group consisting of tantalum, titanium, aluminum, zirconium, and niobium. When the electrode 1 is used as an electrode for electrochemical measurement in which an object is a ferricyanide compound, the first metal improves the activity with respect to the ferricyanide compound.

A volume ratio of the first metal is, for example, 10 parts by volume or more, preferably 25 parts by volume or more, more preferably 60 parts by volume or more, further more preferably 75 parts by volume or more, and for example, 95 parts by volume or less, preferably 90 parts by volume or less with respect to 100 parts by volume of the total amount of the first metal and the second metal. The volume ratio of the first metal is, for example, 10% by volume or more, preferably 25% by volume or more, more preferably 60% by volume or more, further more preferably 75% by volume or more, and for example, 95% by volume or less, preferably 90% by volume or less with respect to the alloy.

When the volume ratio of the first metal is the above-described lower limit or more, it is possible to widen the potential window when the electrode is used as the electrode for electrochemical measurement. When the volume ratio of the first metal is the above-described upper limit or less, it is possible to improve the activity with respect to the ferricyanide compound.

### 1.2.2 Second Metal

The second metal has a second potential window and second activity. The electrode 1 is required to have the high activity with respect to the ferricyanide compound.

The second potential window is obtained using a second electrochemical measurement system 10B shown in FIG. 3. In the electrode 1, the potential window is required to be wide. The second electrochemical measurement system 10B includes a second sample electrode 1B. As shown in FIG. 2, the second sample electrode 1B includes the substrate 2, the metal underlying layer 3 made of the second metal, and an electrically conductive carbon layer 4B. The second sample electrode 1B further includes the insulating tape 5.

The second activity is evaluated in the ΔEp with respect to the ferricyanide compound determined by CV using the second electrochemical measurement system 10B.

The second sample electrode 1B, the measurement of the second potential window using the second sample electrode 1B, and the measurement of the second activity using the second sample electrode 1B are described later.

The first metal and the second metal are different from each other.

The second activity is equal to or greater than the first activity, and the first potential window is equal to or greater than the second potential window.

Preferably, the second activity is higher than the first activity, and the first potential window is equal to or greater than the second potential window. Further, preferably, the second activity is equal to or greater than the first activity, and the first potential window is wide with respect to the second potential window.

More preferably, the second activity is higher than the first activity, and the first potential window is wide with respect to the second potential window.

The second metal is, for example, a typical element and/or a transition element. Preferably, the second metal is at least one selected from the group consisting of tantalum, titanium, aluminum, zirconium, niobium, and tungsten. In other words, each of the first metal and the second metal is at least one selected from the group consisting of tantalum, titanium, aluminum, zirconium, niobium, and tungsten.

More preferably, the second metal is at least one selected from the group consisting of zirconium, niobium, and tungsten.

The first metal or the second metal preferably includes two selected from the group consisting of tantalum, titanium, aluminum, zirconium, niobium, and tungsten. In the following, examples of combinations of the first metal and the second metal are shown.

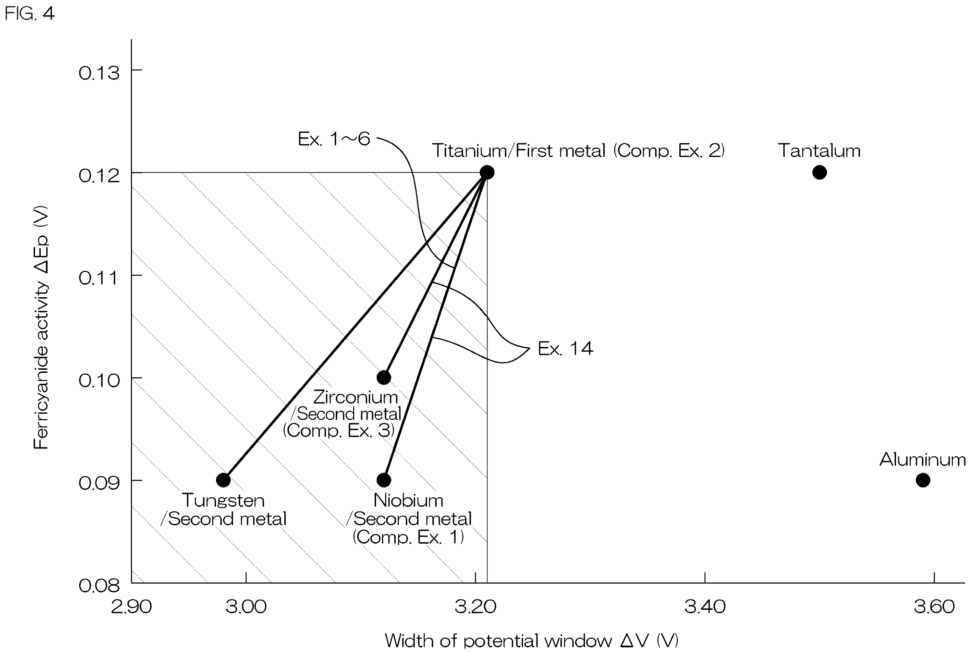

FIGS. 4 to 8 show the relationship between the width of the potential window and ferricyanide activity in the first metal and the second metal. In FIGS. 4 to 8, the combinations of the first metal and the second metal are connected by line segments.

As shown in FIG. 4, examples of the combination of the first metal and the second metal include a case where the first metal is titanium and the second metal is zirconium, a case where the first metal is titanium and the second metal is niobium, a case where the first metal is titanium and the second metal is tungsten, and a case where the first metal is titanium and the second metal is zirconium and niobium. As shown in FIG. 4, when the first metal is titanium, at least one selected from the group consisting of zirconium, niobium, and tungsten in which the second potential window and the second activity are plotted in a region shown by hatching is selected as the second metal.

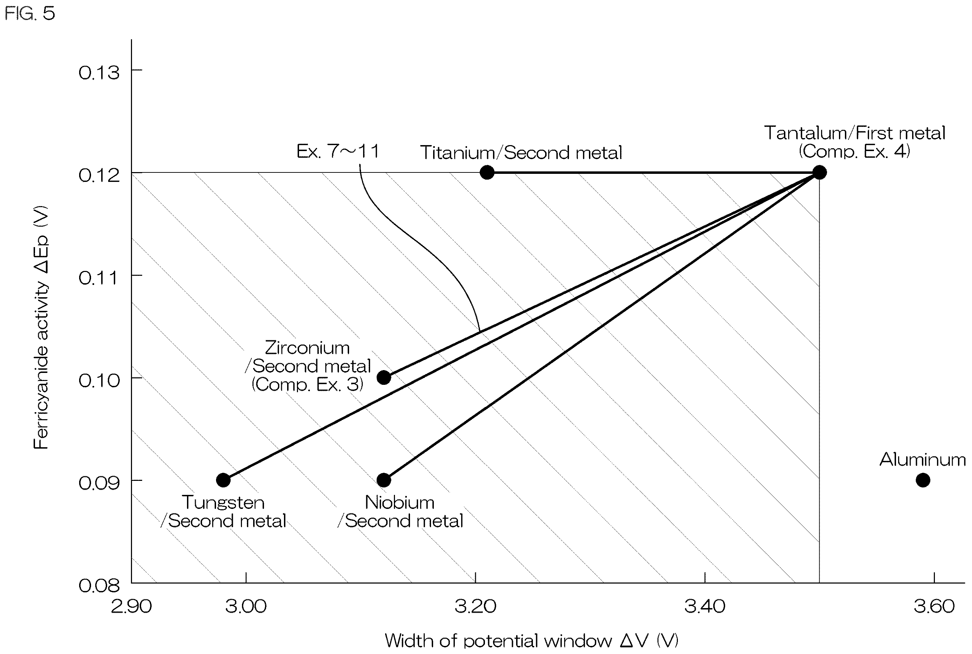

As shown in FIG. 5, examples of the combination of the first metal and the second metal include a case where the first metal is tantalum and the second metal is titanium, a case where the first metal is tantalum and the second metal is zirconium, a case where the first metal is tantalum and the second metal is niobium, and a case where the first metal is tantalum and the second metal is tungsten. As shown in FIG. 5, when the second metal is tantalum, at least one selected from the group consisting of titanium, zirconium, niobium, and tungsten in which the second potential window and the second activity are plotted in the region shown by hatching is selected as the second metal.

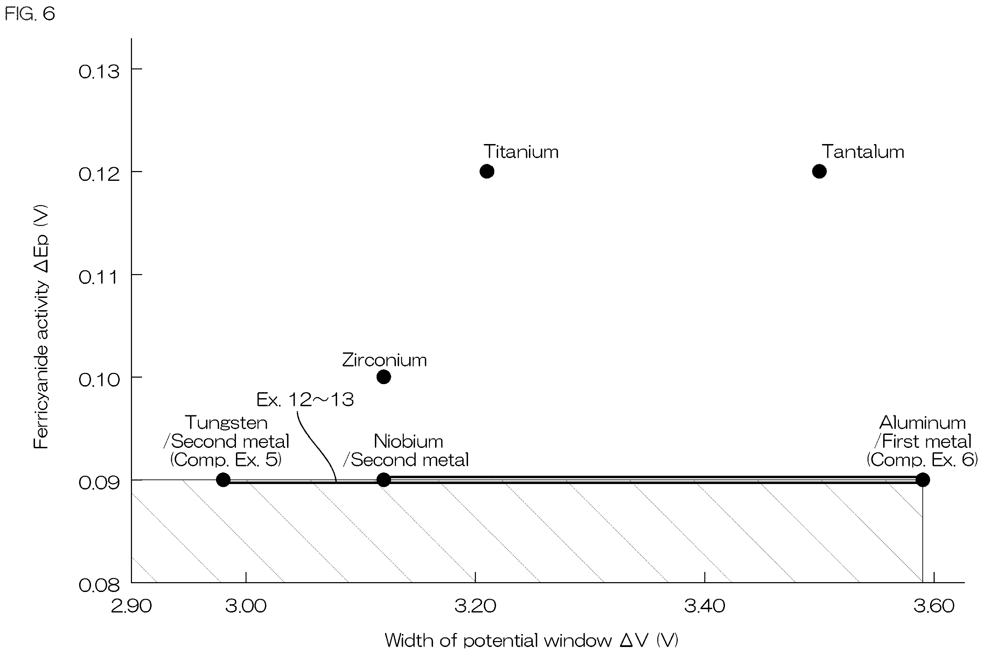

As shown in FIG. 6, examples of the combination of the first metal and the second metal include a case where the first metal is aluminum and the second metal is niobium and a case where the first metal is aluminum and the second metal is tungsten. As shown in FIG. 6, when the second metal is aluminum, at least one selected from the group consisting of niobium and tungsten in which the second potential window and the second activity are plotted in the region shown by hatching is selected as the second metal.

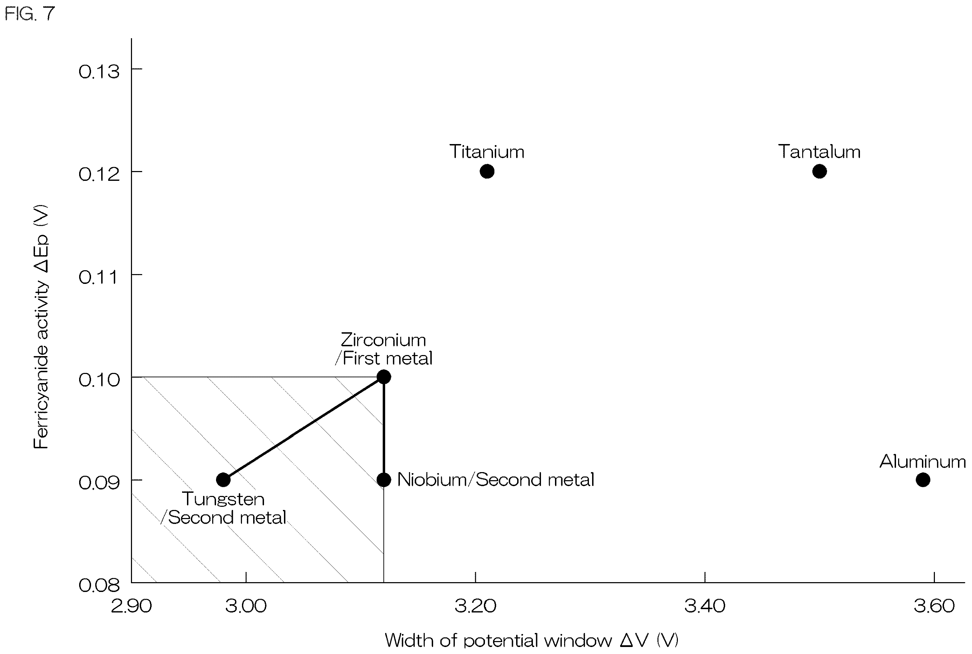

As shown in FIG. 7, examples of the combination of the first metal and the second metal include a case where the first metal is zirconium and the second metal is niobium and a case where the first metal is zirconium and the second metal is tungsten. As shown in FIG. 7, when the second metal is zirconium, at least one selected from the group consisting of niobium and tungsten in which the second potential window and the second activity are plotted in the region shown by hatching is selected as the second metal.

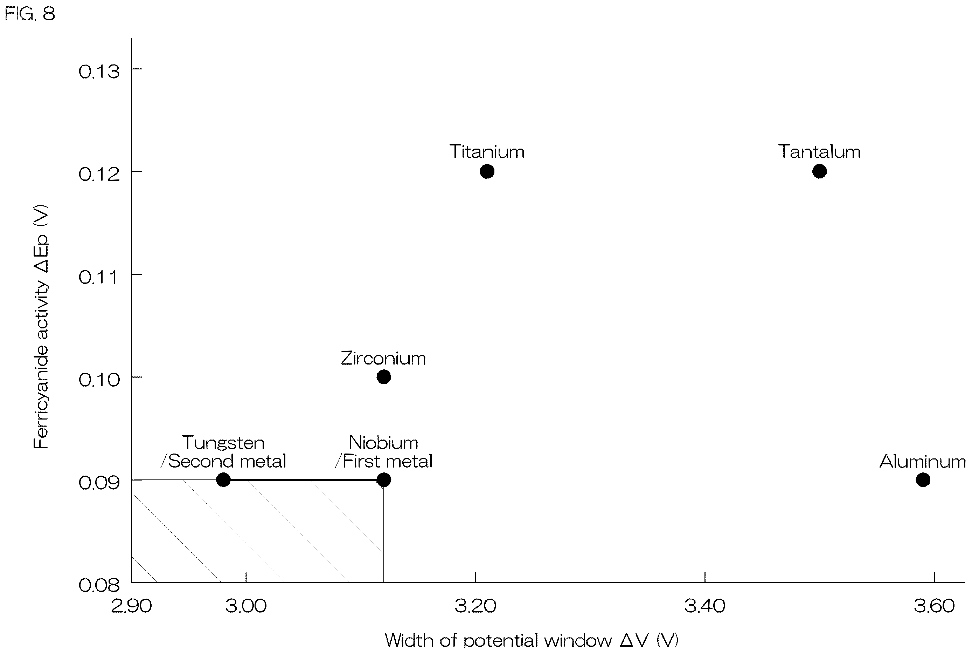

As shown in FIG. 8, an example of the combination of the first metal and the second metal includes a case where the first metal is niobium and the second metal is tungsten. As shown in FIG. 8, when the second metal is niobium, tungsten in which the second potential window and the second activity are plotted in the region shown by hatching is selected as the second metal.

The volume ratio of the second metal is, for example, 5 parts by volume or more, preferably 10 parts by volume or more, and for example, 90 parts by volume or less, preferably 75 parts by volume or less, more preferably 40 parts by volume or less, further more preferably 25 parts by volume or less with respect to 100 parts by volume of the total amount of the first metal and the second metal. The volume ratio of the second metal is, for example, 5% by volume or more, preferably 10% by volume or more, and for example, 90% by volume or less, preferably 75% by volume or less, more preferably 40% by volume or less, further more preferably 25% by volume or less with respect to the alloy.

When the volume ratio of the second metal is the above-described upper limit or less, it is possible to widen the potential window when the electrode is used as the electrode for electrochemical measurement. When the volume ratio of the second metal is the above-described lower limit or more, it is possible to improve the activity with respect to the ferricyanide compound.

Each of the first metal and the second metal is identified by ESCA, SEM-EDX, TEM-EDX, and/or XRF. An identification method is not limited to the description above.

The thickness of the metal underlying layer 3 is, for example, 5 nm or more, preferably 10 nm or more, more preferably 15 nm, further more preferably 20 nm or more, and for example, 400 nm or less, preferably 200 nm or less, more preferably 100 nm or less, further more preferably 50 nm or less.

### 1.3 Electrically Conductive Carbon Layer 4

The electrically conductive carbon layer 4 is disposed in one end portion of the electrode 1 in the thickness direction. The electrically conductive carbon layer 4 is disposed on one surface of the metal underlying layer 3 in the thickness direction. The electrically conductive carbon layer 4 is in contact with one surface of the metal underlying layer 3 in the thickness direction. The electrically conductive carbon layer 4 is disposed at the opposite side of the substrate 2 with respect to the metal underlying layer 3 in the thickness direction.

The electrically conductive carbon layer 4 may also, for example, include sp² bond and sp³ bond. When the electrically conductive carbon layer 4 includes the sp² bond and the sp³ bond, the electrically conductive carbon layer 4 has a graphite-type structure and a diamond structure. The electrically conductive carbon layer 4 may, for example, contain oxygen other than carbon. Furthermore, in the electrically conductive carbon layer 4, a trace amount of inevitable impurities other than the oxygen is allowed to be mixed.

The thickness of the electrically conductive carbon layer 4 is, for example, 0.1 nm or more, preferably 0.2 nm or more, and 100 nm or less, preferably 50 nm or less.

### 1.4 Method for Producing Electrode 1

In this method, first, the substrate 2 is prepared.

In this method, next, the metal underlying layer 3 is formed on one surface of the substrate 2 in the thickness direction. Examples of a method for forming the metal underlying layer 3 include dry methods and wet methods. As the method for forming the metal underlying layer 3, preferably, a dry method is used. Examples of the dry method include PVD methods (physical deposition methods) and CVD methods (chemical gas phase growth methods), and preferably, a PVD method is used. Examples of the PVD method include sputtering, vacuum deposition, laser deposition, and ion plating. As the PVD, preferably, sputtering is used. In the sputtering, a sputtering device is used. The sputtering device includes a first target including the first metal and a second target including the second metal. When the plurality of first metals are used, a portion of the first metal may be included in the first target and the remaining portion of the first metal may be included in the second target. When the plurality of second metals are used, a portion of the second metal may be included in the second target and the remaining portion of the second metal may be included in the first target.

The first target and the second target are spaced apart from each other. Electric power can be applied to each of the first target and the second target. The electric power applied to each of the first target and the second target is appropriately set in accordance with the volume ratio of each of the first metal and the second metal. Examples of the sputtering gas include inert gases. An example of the inert gas includes Ar. Pressure in the sputtering is, for example, 0.01 Pa or more and 5 Pa or less. A film forming temperature is, for example, -10°C or more, preferably 20°C or more, and for example, 200°C or less, preferably 150°C or less.

In this method, thereafter, the electrically conductive carbon layer 4 is formed on one surface of the metal underlying layer 3 in the thickness direction. The method for forming the electrically conductive carbon layer 4 is not particularly limited. As the method for forming the electrically conductive carbon layer 4, the same method as that for forming the metal underlying layer 3 is used, and preferably, sputtering is used. The target in the sputtering is, for example, sintered carbons.

### 1.5 Use

A use of the electrode 1 is not limited. Preferably, the electrode 1 can be used as an electrode for electrochemical measurement which carries out an electrochemical measurement method, and specifically, as a working electrode (acting electrode) which carries out cyclic voltammetry (CV).

Examples of the target (measurement target) for electrochemical measurement include ferricyanide compounds. Examples of the ferricyanide compound include potassium ferricyanide and sodium ferricyanide.

### 1.6 Electrochemical Measurement System

One embodiment of the electrochemical measurement system of the present invention is described with reference to FIG. 7.

An electrochemical measurement system 10 includes a working electrode 11, a reference electrode 12, a counter electrode 13, a potentiostat 14, and an ammeter which is not shown.

The working electrode 11 includes the above-described electrode 1. In other words, the electrochemical measurement system 10 includes the above-described electrode 1. In other words, the electrode 1 is used in the electrochemical measurement.

Examples of the reference electrode 12 include silver/silver chloride electrodes, saturated calomel electrodes, and standard hydrogen electrodes.

Examples of the counter electrode 13 include platinum electrodes, gold electrodes, and nickel electrodes.

The working electrode 11, the reference electrode 12, and the counter electrode 13 described above can be immersed in a target liquid 15. The target liquid 15 includes the above-described measurement target. For example, when the CV is carried out, and an electric potential is applied to the working electrode 11 (the electrode 1) to be scanned.

### 1.7 Function and Effect of One Embodiment

In the electrode 1, the material for the metal underlying layer 3 is an alloy containing the first metal and the second metal, the second activity is equal to or greater than the first activity, and the first potential window is equal to or greater than the second potential window. Therefore, the electrode 1 has an excellent balance between the activity with respect to the ferricyanide compound and the wide potential window.

As shown in FIG. 7, since the electrochemical measurement system 10 includes the above-described electrode 1, the excellent balance between the activity with respect to the ferricyanide compound and the wide potential window is achieved.

### 2. Modified Examples

Although not shown, the electrode 1 may also further include a hard coat layer. The hard coat layer is, for example, disposed on the other surface of the substrate 2 in the thickness direction.

The sputtering may also include only one target. The target consists of the alloy containing the first metal and the second metal.

### Examples

Next, the present invention is further described based on Examples and Comparative Examples below. The present invention is however not limited by these Examples and Comparative Examples. The specific numerical values in volume ratio (content ratio), property value, and parameter used in the following description can be replaced with upper limit values (numerical values defined as "or less" or "below") or lower limit values (numerical values defined as "or more" or "above") of corresponding numerical values in volume ratio (content ratio), property value, and parameter described in the above-described "DESCRIPTION OF EMBODIMENTS".

### Example 1

First, the substrate 2 made of polyethylene terephthalate having the thickness of 100 µm was prepared.

Next, the metal underlying layer 3 is formed on one surface of the substrate 2 in the thickness direction by the sputtering. The thickness of the metal underlying layer 3 was 30 nm. The conditions for the sputtering are described below.

First target: titanium
Second target: niobium
Sputtering gas: Ar
Sputtering pressure: 0.3 Pa
Electric power of first target: 3.3 W/cm²
Electric power of second target: 4.3 W/cm²

Thereafter, the electrically conductive carbon layer 4 was formed on one surface of the metal underlying layer 3 in the thickness direction by the sputtering. The thickness of the electrically conductive carbon layer 4 was 10 nm. The conditions for the sputtering are described below.

Target: Sintered carbon
Sputtering gas: Ar
Sputtering pressure: 0.3 Pa
Electric power of target: 3.9 W/cm²

Thus, the electrode 1 was produced.

### Examples 2 to 14 and Comparative Examples 1 to 6

The electrode 1 was obtained in the same manner as Example 1. The composition of the metal underlying layer 3 was changed in accordance with the descriptions of Tables 1 to 4.

### [Evaluation]

### 1. Volume Ratio of First Metal and Second Metal

The volume ratio of each of the first metal and the second metal in the metal underlying layer 3 was calculated based on film forming rates V1 and V2. Specifically, the film forming rate V1 of the first metal was determined by dividing the thickness at the time of film-formation of only the first metal by the product of the electric power and time. The film forming rate V2 of the second metal was determined by dividing the thickness at the time of the film-formation of only the second metal by the product of the electric power and the time. The volume ratio of the first metal and the second metal is determined by a ratio of the film forming rate V1 to the film forming rate V2. The results are described in Tables 1 to 4.

### 2. Activity to Potassium Ferricyanide

As for each of the electrodes 1 of Examples, the activity with respect to the potassium ferricyanide was evaluated. The results are described in Tables 1 to 4.

Specifically, the insulating tape 5 having a hole having a diameter of 2 mm was attached to one surface of the electrically conductive carbon layer 4 in the thickness direction, thereby fabricating a sample electrode 1S having the electrode area of 3.14 mm². The cyclic voltammetry (CV) was carried out using the sample electrode 1S as the working electrode 11. Specifically, the sample electrode 1S was immersed in a 1M KCl aqueous solution. Further, 1 mM of [Fe(CN)₆]⁴⁻ (ion ferricyanide) was added to the aqueous solution as an electroactive material. In the CV measurement, a sweep of the electric potential was started from 0 V, and the electric potential was swept from positive to negative in a range of -0.1 to 0.5 V. A sweep rate of the electric potential was 0.1 V/s. The CV measurement was carried out at 23°C. Measurement numbers of the CV were 3. An average value of the three ΔEp value in the CV measurement was obtained as initial ΔEp. The ΔEp at this time was referred to as the activity of the electrode 1 with respect to the potassium ferricyanide.

On the other hand, each of the sample electrodes of Comparative Examples was referred to as the first sample electrode 1A or the second sample electrode 1B. Then, the ΔEp of the first sample electrode 1A measured in the same manner as the description above was referred to as the first activity. The ΔEp of the second sample electrode 1B was referred to as the second activity.

### 3. Width of Potential Window

As for each of the electrodes 1 of Examples, the width of the potential window was evaluated. The results are described in Tables 1 to 4.

Specifically, the insulating tape 5 having the hole having the diameter of 2 mm was attached to one surface of the electrically conductive carbon layer 4 in the thickness direction, thereby fabricating the sample electrode 1S having the electrode area of 3.14 mm². Each of the electrochemical measurement systems 10 of Examples and Comparative Examples was fabricated by being connected to the potentiostat (description above) with the sample electrode 1S as the working electrode 11, the silver/silver chloride electrode as the reference electrode, and the platinum electrode as the counter electrode. As an electrolytic solution, 50 mmol/L of sulfuric acid aqueous solution was used.

The electric potential was applied to the reference electrode of the electrochemical measurement system 10 at the sweep rate of 0.1 V/s. A potential range in which a current value obtained at this time was -509 µA/cm² to +509 µA/cm² was defined as the range of the potential window. The range of the potential window was determined as ΔV (V) of a difference (distance) between the maximum electric potential on the oxidation side and the electric potential on the deoxidization side.

On the other hand, each of the sample electrodes of Comparative Examples was referred to as the first sample electrode 1A or the second sample electrode 1B. Then, ΔV of the first sample electrode 1A measured in the same manner as the description above was referred to as the first potential window. The ΔV of the second sample electrode 1B was referred to as the second potential window.

The results are shown in Tables 1 to 4.

### [Table 1]

**Table 1**

| | | | Comp. Ex. 1 | Ex. 1 | Ex. 2 | Ex. 3 | Ex. 4 | Ex. 5 | Ex. 6 | Comp. Ex. 2 |
|---|---|---|---|---|---|---|---|---|---|---|
| Electric Power Applied to Target (W/cm²) | First Target (Titanium) | | - | 3.3 | 4.5 | 4.9 | 4.9 | 7.4 | 7.4 | 3.9 |
| | Second Target (Niobium) | | 3.9 | 4.3 | 3.9 | 1.8 | 0.8 | 2.9 | 2.2 | - |
| Metal Underlying Layer (Alloy) | First Metal | Titanium (% by volume) | 0 | 20 | 30 | 50 | 70 | 75 | 80 | 100 |
| | Second Metal | Niobium (% by volume) | 100 | 80 | 70 | 50 | 30 | 25 | 20 | 0 |
| Evaluation | Potential Window ΔV (V) | | 3.12^{*1} | 3.14 | 3.13 | 3.15 | 3.2 | 3.27 | 3.29 | 3.21^{*3} |
| | Ferricyanide Activity ΔEp (V) | | 0.09^{*2} | 0.09 | 0.08 | 0.09 | 0.08 | 0.09 | 0.08 | 0.12^{*4} |

| | | | | | | | | | | |
|---|---|---|---|---|---|---|---|---|---|---|
| *1: Second Potential Window *3: First Potential Window *2: Second Activity *4: First Activity | | | | | | | | | | |

### [Table 2]

**Table 2**

| | | | Comp. Ex. 3 | Ex. 7 | Ex. 8 | Ex. 9 | Ex. 10 | Ex. 11 | Comp. Ex. 4 |
|---|---|---|---|---|---|---|---|---|---|
| Electric Power Applied to Target (W/cm²) | First Target (Tantalum) | | - | 1.3 | 2.3 | 3.9 | 3.9 | 3.9 | 3.9 |
| | Second Target (Zicronium) | | 3.9 | 4.0 | 4.0 | 2.9 | 1.2 | 0.7 | - |
| Metal Underlying Layer (Alloy) | First Metal | Tantalum (% by volume) | 0 | 20 | 30 | 50 | 70 | 80 | 100 |
| | Second Metal | Zirconium (% by volume) | 100 | 80 | 70 | 50 | 30 | 20 | 0 |
| Evaluation | Potential Window Δ V (V) | | 3.12^{*1} | 3.75 | 3.88 | 3.82 | 3.62 | 3.55 | 3.50^{*3} |
| | Ferricyanide Activity Δ Ep (V) | | 0.10^{*2} | 0.09 | 0.09 | 0.10 | 0.10 | 0.09 | 0.12^{*4} |

| | | | | | | | | | |
|---|---|---|---|---|---|---|---|---|---|
| *1: Second Potential Window *3: First Potential Window *2: Second Activity *4: First Activity | | | | | | | | | |

### [Table 3]

**Table 3**

| | | | Comp. Ex. 5 | Ex. 12 | Ex. 13 | Comp. Ex. 6 |
|---|---|---|---|---|---|---|
| Electric Power Applied to Target (W/cm²) | First Target (Aluminum) | | - | 3.9 | 3.9 | 3.9 |
| | Second Target (Tungsten) | | 3.9 | 2.6 | 1.1 | - |
| Metal Underlying Layer (Alloy) | First Metal | Aluminum (% by volume) | 0 | 50 | 70 | 100 |
| | Second Metal | Tungsten (% by volume) | 100 | 50 | 30 | 0 |
| Evaluation | Potential Window Δ V (V) | | 2.98*1 | 3.10 | 3.14 | 3.59^{*3} |
| | Ferricyanide Activity Δ Ep (V) | | 0.09^{*2} | 0.08 | 0.08 | 0.09^{*4} |

| | | | | | | |
|---|---|---|---|---|---|---|
| *1: Second Potential Window *3: First Potential Window *2: Second Activity *4: First Activity | | | | | | |

### [Table 4]

**Table 4**

| | | | Comp. Ex. 3 | Comp. Ex. 1 | Comp. Ex. 2 | Ex. 14 |
|---|---|---|---|---|---|---|
| Electric Power Applied to Target (W/cm²) | First Target | Titanium | - | - | 3.9 | 3.9^{*5} |
| | | Niobium | - | 3.9 | - | |
| | Second Target | Zirconium | 3.9 | - | - | 1.9 |
| Metal Underlying Layer (Alloy) | First Metal | Titanium (% by volume) | 0 | 0 | 100 | 47 |
| | Second Metal | Niobium (% by volume) | 0 | 100 | 0 | 3 |
| | | Zirconium (% by volume) | 100 | 0 | 0 | 50 |
| Evaluation | Width of Potential Window Δ V (V) | | 3.12^{*1} | 3.12^{*1} | 3.21^{*3} | 3.19 |
| | Ferricyanide Activity Δ Ep (V) | | 0.10^{*2} | 0.09^{*2} | 0.12^{*4} | 0.10 |

| | | | | | | |
|---|---|---|---|---|---|---|
| *1: Second Potential Window *3: First Potential Window *2: Second Activity *4: First Activity *5: Titanium-Niobium Alloy (Volume Ratio= 94:6) | | | | | | |

- 3: Metal underlying layer
- 4: Electrically conductive carbon layer
- 5: Insulating tape
- 10: Electrochemical measurement system
- 10A: First electrochemical measurement system
- 10B: Second electrochemical measurement system

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

### INDUSTRIAL APPLICATION

The electrode and the electrochemical measurement system of the present invention are preferably used in the electrochemical measurement fields.

## Claims

1. An electrode comprising:
a substrate, a metal underlying layer, and an electrically conductive carbon layer in order toward one side in a thickness direction, wherein
a material for the metal underlying layer is an alloy containing a first metal and a second metal;
the first metal has a first potential window obtained by using a first electrochemical measurement system including a first sample electrode including the substrate, the metal underlying layer made of the first metal, and the electrically conductive carbon layer, and first activity with respect to a ferricyanide compound obtained by using the first electrochemical measurement system;
the second metal has a second potential window obtained by using a second electrochemical measurement system including a second sample electrode including the substrate, the metal underlying layer made of the second metal, and the electrically conductive carbon layer, and second activity with respect to the ferricyanide compound obtained by using the second electrochemical measurement system;
the first metal and the second metal are different from each other;
the second activity is equal to or greater than the first activity; and
the first potential window is equal to or greater than the second potential window.

2. The electrode according to claim 1, wherein
the first metal or the second metal is at least one selected from the group consisting of tantalum, titanium, aluminum, zirconium, niobium, and tungsten.

3. The electrode according to claim 2, wherein
the first metal is at least one selected from the group consisting of tantalum, titanium, aluminum, zirconium, and niobium.

4. The electrode according to claim 2, wherein
the second metal is at least one selected from the group consisting of zirconium, niobium, and tungsten.

5. The electrode according to claim 2, wherein
the first metal or the second metal includes two selected from the group consisting of tantalum, titanium, aluminum, zirconium, niobium, and tungsten.

6. The electrode according to claim 1 or 2, wherein
the substrate is a resin film.

7. The electrode according to claim 1 or 2 being an electrode for electrochemical measurement.

8. An electrochemical measurement system comprising the electrode according to claim 7.
